# EUROPEAN PATENT SPECIFICATION

(11) **EP 1 207 215 B1**
(45) Date of publication and mention of the grant of the patent: **24.07.2013**
(21) Application number: 01127023.8
(22) Date of filing: 14.11.2001
(51) Int. Cl.: C23C 16/30, C23C 16/44, C30B 25/02, C30B 29/40, C30B 25/08, H01L 21/20

(54) **A method for fabricating a III-V nitride film and an apparatus for fabricating the same**
Herstellungsverfahren von III-V Nitrid Film und Herstellungsvorrichtung
Procédé de fabrication de couche de nitrure III-V et dispositif de fabrication

(30) Priority: 15.11.2000 JP 2000347735
(43) Date of publication of application: 22.05.2002
(73) Proprietor: NGK Insulators, Ltd., Nagoya City, Aichi Pref. (JP)
(72) Inventor: Shibata, Tomohiko, Nagoya City, Aichi Pref., (JP); Nakamura, Yukinori, Nagoya City, Aichi Pref., (JP); Tanaka, Mitsuhiro, Nagoya City, Aichi Pref., (JP); Asai, Keiichiro, Nagoya City, Aichi Pref., (JP)
(74) Representative: TBK

(56) References cited:
- EP-A- 1 160 354
- US-A- 5 119 541
- US-A- 5 599 732
- US-A- 6 146 464
- PATENT ABSTRACTS OF JAPAN vol. 1999, no. 01, 29 January 1999 (1999-01-29) & JP 10 284425 A (ROHM CO LTD), 23 October 1998 (1998-10-23)
- PATENT ABSTRACTS OF JAPAN vol. 1998, no. 08, 30 June 1998 (1998-06-30) & JP 10 067584 A (SHIN ETSU CHEM CO LTD), 10 March 1998 (1998-03-10)

## Description

### Background of the invention

### (1) Field of the invention

This invention relates to a method to epitaxially grow a III-V nitride film, particularly AlxGayInzN (x+y+z=1) film on a given substrate by a Metal Organic Chemical Vapor Deposition (MOCVD) method and an apparatus for the same method.

### (2) Related Art Statement

In opto-electronic devices such as light-emitting diodes, laser diodes or photodiodes, it is proposed that III-V nitride films having their compositions of AlxGayInzN(X+Y+Z=1) is epitaxially grown on a given substrate made of sapphire single crystal, for example. Up to now, the epitaxial growth of the AlxGayInzN film has been performed by a MOCVD method or recently, a Hydride Vapor Phase Epitaxy (HVPE) method.

In the case of making a GaN film by a HVPE method, first of all, a substrate made of sapphire single crystal is set into a reactor in which a gallium metallic material is charged. Then, a hydrochloric acid gas is introduced into the reactor and reacted with the gallium metallic material, to generate a hydrochloric gallium gas. Then, an ammonia gas is introduced into the reactor and reacted with the hydrochloric gallium gas, to deposit and fabricate the GaN film on the substrate. The HVPE method has a higher film growth rate than a MOCVD method or a MOVPE method. For example, in the MOVPE method, a GaN film can be epitaxially grown typically at only several µm/hour, but in the HVPE method, the GaN film can be epitaxially grown typically at several hundreds µm/hour. Therefore, the HVPE method has its advantage in forming a thicker III-V nitride film.

However, a good quality AlxGayInzN film can not be provided by the HVPE method, and the fluctuation in thickness on the same substrate may be increased. On the other hand, it takes much time to form the AlxGayInzN film by the MOVPE method, and thus, the fabrication cost of the AlxGayInzN film rises.

In the case of making an AlxGayInzN (x+y+z=1) film by a MOCVD method, a given substrate is set and held on a susceptor installed in a reactor, and is heated to a predetermined temperature by a heater. Then, a trimethylaluminum gas, a trimethylgallium gas, a trimethylindium gas or the like as III raw material gases are introduced with a carrier gas composed of a hydrogen gas or a nitrogen gas into the reactor. On the other hand, an ammonia gas as a V raw material gas is introduced with a carrier gas composed of a hydrogen gas or a nitrogen gas into the reactor. Then, the III raw material gases and the V raw material gas are reacted, to deposit and form the AlxGayInzN film on the substrate. As the AlxGayInzN film, an aluminum nitride film, a gallium nitride film, an indium nitride film, an aluminum-gallium nitride film, an aluminum-indium nitride film and a gallium-indium nitride film are exemplified.

In the above conventional method such as a MOCVD method, if the reaction between the III raw material gases and the V raw material gas is created on the wall surfaces of the reactor, the film-forming efficiency is degraded, and thus, the film growth rate is decreased. In the past, therefore, the raw material gases are cooled down at their introduction to the reactor, or the interior wall of the reactor are partially cooled down.

On the other hand, the ammonia gas as the V raw material gas exhibits its intensive corrosion property. Therefore, the heated parts of the interior wall of the reactor may be coated by a protective layer made of SiC, p-BN, TaCx, NbNx, etc., so as to prevent the corrosion of the interior wall. In this case, if the reaction between the III raw material gases and the V raw material gas is created on the wall surfaces of the reactor, the resulting AlpGaqInrN (p+q+r=1) compound is not deposited on the protective layer, but is drop off of the protective layer as particles.

Particularly, at the highly heated parts of the protective layer, more particles composed of the AlpGaqInrN compound are created through the gas phase reaction between the III raw material gases and the V raw material gas due to the catalytic effect of the interior wall of the reactor. In the case of using a trimethylaluminum gas as one of the III raw material gases for making an AlN film or an Al-rich AlxGayInzN (x+y+z=1, x>0.5) film, many particles are easily created due to the higher reactivity of the trimethylaluminum gas.

The resulting particles are drop off from on the protective layer, as mentioned above, and blown off by the raw material gases or the carrier gas and deposited onto a substrate. In this case, the quality of the resulting AlxGayInzN film, particularly an AIN film or an Al-rich AlxGayInzN film is deteriorated due to the deposited particles.

In addition, since the substrate on which the AlxGayInzN film is formed is heated through a susceptor which is initially heated with a heater, the surface temperature of the susceptor is raised to higher temperature of 1000°C or over than the substrate temperature, so that more particles composed of the AlpGaqInrN compound are easily created on the surface of the susceptor. Then, the created particles are deposited on the substrate, and thus, the quality of the resulting AlxGayInzN film is deteriorated.

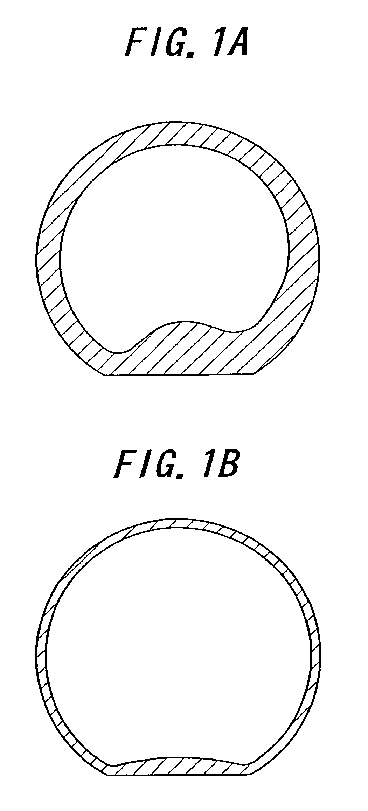

Fig. 1A is a conceptual view showing the film quality of an AIN film formed on a substrate made of a 3-inch wafer using a new susceptor. The quality deterioration of the AIN film is designated by the hatched region at the periphery of the substrate. As shown in Fig. 1A, the quality of the AIN film is remarkably deteriorated by using the new susceptor due to the particle deposition.

Moreover, when using such a large substrate as a 3-inch wafer so as to reduce the fabrication cost, the quality deterioration of the resulting AlxGayInzN film becomes remarkable due to more particles at the periphery of the substrate.

US 5,599,732 A discloses a method for growing III-V semiconductor films using a coated reaction chamber.

Further, JP 10-284425 A discloses the manufacture of semiconductor device. In the method for manufacturing a semiconductor device, a substrate 2 is placed on a platter 1 within a reaction apparatus, and reacted with a reaction gas while heating the platter 1 to thereby epitaxially grow a semiconductor layer of gallium nitride compound on the substrate. In this case, a film 5 of AlₓIn_{y}Ga_{1-x-y}N (x+y<1) is previously coated on the platter 1, and then the substrate 2 is placed on the film 5 for its epitaxial growth.

JP 10-067584 A discloses a reaction vessel obtained by generating a thermally decomposed boron nitride having a very high impact resistance and no gas penetrating property by a chemical vapor phase deposition method, forming a main body of the reaction vessel having 1-5mm thickness and a shape corresponding to the objective use, generating an aluminum nitride not corroded by oxygen or fluorine by a chemical vapor deposition method, and coating the inner wall of the main body of the reaction vessel by 1-50µm thickness with the aluminum nitride having <100nm crystallite size.

Further prior art which is related to this field of technology can be found e. g. in US 6 146 464 A disclosing a susceptor for deposition apparatus and document US 5 119 541 A disclosing a wafer succeptor apparatus.

### Summary of the Invention

It is an object of the present invention to work out the above conventional problems, and thus, to provide a method and an apparatus for epitaxially growing a good quality AlxGayInzN film (x+y+z=1) by a MOCVD method.

In order to achieve the above object, this invention relates to a method according to claim 1.

The coated AlaGabIncN (a+b+c=1, a>0) film includes unavoidable elements such as oxygen element, silicon element, magnesium element and another element containing in the interior wall of the reactor by several %. Moreover, the AlaGabIncN film is not required to have a uniform composition over the total thickness, but may have a continuously or stepwisely inclined composition or an multi-layered structure composed of plural films having their respective different compositions.

In an example useful for understanding the present invention, an AlaGabIncN (a+b+c=1, a>0) film is coated on the susceptor to hold the substrate. In the case of making a III-V nitride film by a MOCVD method, as mentioned above, the substrate is heated to around 1000°C, and thus, the surface of the susceptor is heated to 1000°C or over. Therefore, more particles composed of the AlpGaqInrN (p+q+r=1) compound is likely to be created on the susceptor. However, if the susceptor is coated with the AlaGabIncN film, the AlpGaqInrN compound is deposited directly on the susceptor, and thus, the particles are not created and deposited on the substrate. As a result, the resulting AlxGayInzN film can have its desirable quality.

Herein, the particles means not only "particles having diameter of more than 0.1 µm", but also "much smaller-scale intermediate products like polymers made from III raw materials, including especially aluminum and V raw materials."

The fabricating method of the present invention may be preferably usable in forming an Al-rich AlxGayInzN (x+y+z=1, x>0.5) film or an AIN film by introducing into the reactor much amount of trimethylaluminum gas with an ammonia gas.

Particularly, in the case of making the Al-rich AlxGayInzN film or the AIN film, the AlaGabIncN film to be formed on the interior wall of the reactor and/or the susceptor includes relatively large amount of Al element, preferably 50 atomic percentages or over (a>0.5), more preferably 100 atomic percentages (a=1.0, that is, an AlN film). In this case, the Al-rich AlpGaqInrN compound is efficiently deposited on the Al-rich AlaGabIncN film coated on the susceptor and/or the interior wall of the reactor, and thus, the particles composed of the Al-rich AlpGaqInrN compound are not almost created.

This invention also relates to an apparatus for fabricating a III- V nitride film by a MOCVD method, according to the corresponding independent claim.

In the fabricating apparatus according to an example useful for understanding the present invention, too, the interior wall of the reactor and/or the susceptor is preferably coated with an Al-rich AlaGabIncN film or an AIN film when an Al-rich AlxGayInzN film or an AIN film is made by a MOCVD method using a III raw material gas such as a trimethylaluminum gas and a V raw material gas such as an ammonia gas, as mentioned above. Therefore, the fabricating method of the present invention may be preferably usable in forming an Al-rich AlxGayInzN (x+y+z=1, x>0.5) film or an AlN film by introducing into the reactor much amount of trimethylaluminum gas with an ammonia gas.

### Brief Description of the Drawings

For better understanding of the present invention, reference is made to the attached drawings, wherein
Fig. 1A is a conceptual view showing the film quality of an AIN film formed on a substrate made of a 3-inch wafer, made by a method according to the present invention,
Fig. 1B is a conceptual view showing the film quality of an AIN film, made by a method according to the present invention,
Fig. 2 is a cross sectional view diagrammatically showing the structure of a fabricating apparatus for a III-V nitride film according to an example useful for understand the present invention,
Fig. 3 is a cross sectional view showing the susceptor of the fabricating apparatus, and
Fig. 4 is a cross sectional view showing the susceptor of another fabricating apparatus according to the present invention.

### Description of the Preferred Embodiments

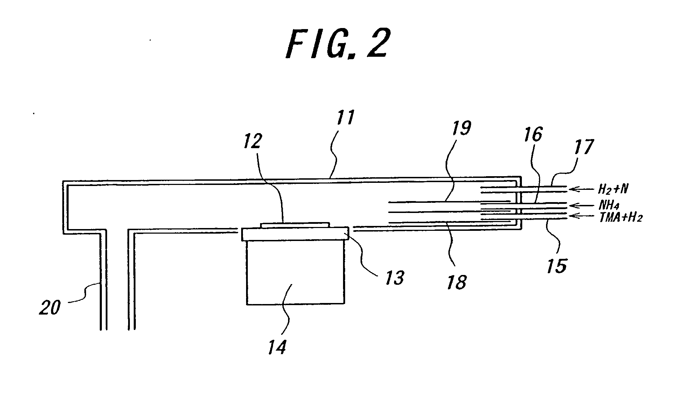

Fig. 2 is a cross sectional view diagrammatically showing the structure of a fabricating apparatus for a III-V nitride film according to an example useful for understanding the present invention. In Fig. 2, the fabricating apparatus includes a reactor 11 made of quartz or stainless, a susceptor 13 at the center in the lower side of the reactor and a heater 14 under the susceptor 13. A substrate 12 made of, e.g., sapphire single crystal is set horizontally on the susceptor and heated to a predetermined temperature with the heater. Although, in Fig. 2, the substrate is held on the upper surface of the susceptor, it may be held on the lower surface.

At the right side of the reactor 11 are provided gas inlets 15-17 to introduce raw material gases with a carrier gas. In the case of making an AlN film, for example, a trimethylaluminum gas is introduced with a hydrogen carrier gas from the first gas inlet 15, and an ammonia gas is introduced from the second gas inlet 16. Then, a carrier gas composed of a hydrogen gas or a nitrogen gas is introduced from the third gas inlet 17. The introduced trimethylaluminum gas and the introduced ammonia gas are also introduced into the center region of the reactor through separated guiding tubes 18 and 19, respectively. In this case, the raw material gases are effectively supplied onto the substrate 12, and not supplied in the remote region from the substrate 12. The introduced raw material gases are consumed by a MOCVD reaction on the substrate, and the remaining raw material gases are discharged from gas outlet 20 provided at the left side of the reactor 11.

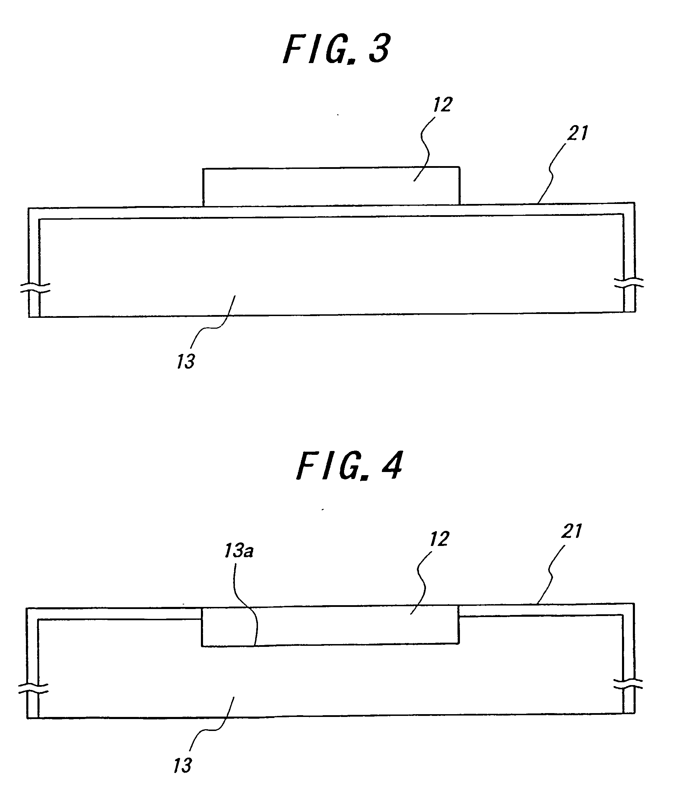

In the case of making an AlN film, the substrate 12 is heated to around 1000°C, for example by the heater 14. In this case, the surface temperature of the susceptor 13 is raised to 1000°C or over. Therefore, the raw material gases are likely to be chemically reacted on the susceptor, to create particles composed of the AlNx compound. The particles are blown off by the raw material gases and the carrier gases and deposited on the substrate 12, to deteriorate the quality of the AlxGayInzN film, for example, an AlN film. Therefore, as shown in Fig. 3, for example, an AlN film 21 is coated in a thickness of 1 µm on the top surface and the side surfaces of the susceptor 13. In this case, the AlNx compound is deposited on the coated AlN film 21, and thus, particles composed of the AlNx compound are not almost created. As a result, the resulting AlN film is not affected by the particles, and can have its desirable quality over the almost entire main surface of the substrate including the periphery thereof. Accordingly, the fabricating total cost of the AlN film can be reduced.

Although the example useful for understanding the present invention was described in detail, this invention is not limited to the above disclosure and every kind of variation and modification may be made without departing from the scope of the present invention.

For example, the AIN film 21 may be coated on the interior walls of the reactor and/or another instrument installed in the reactor which are heated to higher temperature of 1000°C or over, instead of coating over the susceptor 13. Then, besides the AlN film, another AlaGabIncN (a+b+c=1, a>0) film or AlaGabIncN (a+b+c=1, a>0.5) film may be coated.

The substrate 12 may be made of, instead of the sapphire single crystal, oxide single crystal such as ZnO single crystal, LiAlO₂ single crystal, LiGaO₂ single crystal, MgAl₂O₄ single crystal, or MgO single crystal, IV single crystal or IV-IV single crystal such as Si single crystal or SiC single crystal, III-V single crystal such as GaAs single crystal, AIN single crystal, GaN single crystal or AlGaN single crystal, and boride single crystal such as ZrB₂. Moreover, the substrate 12 may be composed of an epitaxial substrate having such a single crystal as mentioned above as a base material and a given epitaxial film formed on the base material.

According to the invention, the substrate 12 is set in a grooved portion 13a formed at the plane main surface of the susceptor 13 as shown in Fig. 4, instead of being set directly on the plane main surface of the susceptor 13. In this case, for not disturbing the raw material gas flow on the substrate 12, it is desired that the grooved portion is formed so that the surface level of the substrate 12 set into the grooved portion can be the same as the surface level of the coated AIN film 21. Moreover, the AIN film 21 is not coated at the connection between the substrate 12 and the susceptor 13. The side surfaces of the susceptor 13 to which the raw material gases are not directly contacted may not be coated.

As mentioned above, according to the fabricating method and the fabricating apparatus for a III-V nitride film of the present invention, an AlaGabIncN (a+b+c=1, a>0) film, particularly an Al-rich AlaGabIncN (a+b+c=1, a>0.5) film, more particularly an Al film may be coated on a interior portion of the reactor which is heated to 1000°C or over. Therefore, the AlpGaqInrN (p+q+r=1) compound generated through the reaction of the raw material gases is deposited on the coated film, and thus, particles made of the AlpGaqInrN compound are not almost created. As a result, the resulting AlxGayInzN film is not affected by the particles, and can have its desirable quality. In addition, the interior portion including the interior wall of the reactor is not almost corroded by an ammonia gas as a V raw material gas because the coated film functions as an anti-corrosive film, so that the durability of the whole fabricating apparatus can be developed.

At least one of the interior wall of a reactor and a susceptor installed in the reactor is coated with an AlaGabIncN (a+b+c=1, a>0) film, which is heated to about 1000°C or over when a substrate is heated to a predetermined temperature so as to generate the MOCVD reaction between a III raw material gas and a V raw material gas. Therefore, the AlpGaqInrN (p+q+r=1) compound generated from the raw material gases is deposited on the coated AlaGabIncN (a+b+c=1, a>0) film, and thus, particles composed of the AlpGaqInrN compound are not almost created. As a result, the resulting AlxGayInzN (x+y+z=1) film is not affected by the particles, and can have its desirable quality.

## Claims

1. A method for fabricating a III-V nitride film, comprising the steps of:
- preparing a susceptor (13) in a reactor (11), wherein the susceptor (13) comprises a grooved portion (13a) and the susceptor (13) is coated with a first AlaGabIncN (a+b+c =1, a>0) film, and the surface of the grooved portion (13a) is not coated with the first AlaGabIncN film;
- setting a substrate (12) in the grooved portion;
- heating the substrate (12) to a predetermined temperature; and
- introducing a III raw material gas and a V raw material gas with a carrier gas onto the substrate (12) prepared in the reactor (11), and thus, fabricating a second AlxGayInzN (x+y+z=1) film by a MOCVD method.

2. The fabricating method according to claim 1, wherein the grooved portion (13a) is formed so that a surface level of the substrate (12) set into the grooved portion (13a) is the same as a surface level of the first AlaGabIncN (a+b+c=1, a>0) film (21).

3. The fabricating method according to claim 1 or 2, wherein the first AlaGabIncN (a+b+c=1, a>0) film (21) includes 50 atomic percentages or over of elemental Al (a>0.5) for all of the III elements.

4. The fabricating method according to claim 3, wherein the first AlaGabIncN (a+b+c=1, a>0) film (21) is composed of an AlN film.

5. The fabricating method according to one of claims 1-4, wherein the second AlxGayInzN (x+y+z=1) film includes 50 atomic percentages or over of Al element (a>0.5) for all of the III elements.

6. The fabricating method according to claim 5, wherein the AlxGayInzN (x+y+z=1) film is composed of an AIN film.

7. The fabricating method according to any of claims 1 to 6, wherein the heating is performed such that such that an interior portion of the reactor (11) is heated to 1000 °C or over, and the first AlaGabIncN (a+b+c=1, a>0) film (21) is coated over the inner portion.

8. The fabricating method according to any of claims 1 to 7, further comprising
forming the first AlaGabIncN (a+b+c=1, a>0) film (21) before the substrate is set into the susceptor.

9. An apparatus for fabricating a III-V nitride film by a MOCVD reaction, comprising:
- a reactor (11) in which the MOCVD reaction between a III raw material gas and a V raw material gas may be generated;
- a susceptor (13) with a grooved portion (13a), wherein the susceptor is installed in the reactor;
- the susceptor (13) is coated with a AlaGabIncN (a+b+c=1, a>0) film (21),
the surface of the grooved portion (13a) is not coated with the AlaGabIncN film (21),
the grooved portion is adapted to hold a substrate (12);
- a heater (14) adapted to heat the substrate (12) held in the grooved portion (13a) via the susceptor (13).

10. The apparatus according to claim 9, further comprising the substrate, wherein the grooved portion (13a) is formed so that a surface level of the substrate (12) set into the grooved portion (13a) is the same as a surface level of the AlaGabIncN (a+b+c=1, a>0) film (21).

11. The fabricating apparatus according to claim 9 or 10, wherein the AlaGabIncN (a+b+c=1, a>0) film (21) includes 50 atomic percentages or over of Al element (a>0.5) for all of the III elements.

12. The fabricating apparatus according to claim 11, wherein the AlaGabIncN (a+b+c=1, a>0) film (21) is composed of an AIN film.

13. The fabricating apparatus according to any of claims 9 to 12, wherein the AlaGabIncN (a+b+c=1, a>0) film (21) is coated over an inner portion of the reactor (11) which is to be heated to 1000 °C or over.

## Patentansprüche

1. Verfahren zum Herstellen einer III-V-Nitritschicht mit den Schritten:
Vorbereiten eines Susceptors (13) in einem Reaktor (11), wobei der Susceptor (13) einen gefurchten Abschnitt (13a) aufweist und der Susceptor (13) mit einer ersten AlaGabIncN-(a+b+c =1, a>0)-Schicht bedeckt ist und die Oberfläche des gefurchten Abschnitts (13a) nicht mit der ersten AlaGabIncN-Schicht bedeckt ist;
Setzen eines Substrats (12) in den gefurchten Abschnitt;
Heizen des Substrats (12) auf eine vorbestimmte Temperatur; und
Einführen eines III-Rohmaterialgases und eines V-Rohmaterialgases mit einem Trägergas auf das Substrat (12), das in dem Reaktor (11) vorbereitet ist, und dadurch Herstellen einer zweiten AlxGayInzN-(x+y+z=1)-Schicht durch ein MOCVD-Verfahren.

2. Herstellungsverfahren nach Anspruch 1, wobei der gefurchte Abschnitt (13a) so geformt ist, dass ein Oberflächenniveau des Substrats (12), das in den gefurchten Abschnitt (13a) gesetzt wird, das gleiche ist wie ein Oberflächenniveau der ersten AlaGabIncN-(a+b+c =1, a>0)-Schicht (21).

3. Herstellungsverfahren nach einem der Ansprüche 1 oder 2, wobei die erste AlaGabIncN-(a+b+c =1, a>0)-Schicht (21) 50 Atomprozent oder mehr von elementarem Al (a>0,5) für alle der III Elemente enthält.

4. Herstellungsverfahren nach Anspruch 3, wobei die erste AlaGabIncN-(a+b+c =1, a>0)-Schicht (21) aus einer AIN-Schicht besteht.

5. Herstellungsverfahren nach einem der Ansprüche 1 bis 4, wobei die zweite AlxGayInzN-(x+y+z=1)-Schicht 50 Atomprozent oder mehr eines Al-Elements (a>0,5) für alle der III-Elemente hält.

6. Herstellungsverfahren nach Anspruch 5, wobei die AlxGayInzN-(x+y+z=1)-Schicht aus einer AlN-Schicht besteht.

7. Herstellungsverfahren nach einem der Ansprüche 1 bis 6, wobei das Heizen so durchgeführt wird, dass ein innerer Abschnitt des Reaktors (11) auf 1000 °C oder mehr geheizt wird, und die erste AlaGabIncN-(a+b+c =1, a>0)-Schicht (21) den inneren Abschnitt bedeckt.

8. Herstellungsverfahren nach einem der Ansprüche 1 bis 7, ferner mit Bilden der ersten AlaGabIncN-(a+b+c =1, a>0)-Schicht (21), bevor das Substrat in den Susceptor gesetzt wird.

9. Vorrichtung zum Herstellen einer III-V-Nitritschicht durch eine MOCVD-Reaktion, mit:
einem Reaktor (11), in dem die MOCVD-Reaktion zwischen einem III-Rohmaterialgas und einem V-Rohmaterialgas erzeugt werden kann;
einem Susceptor (13) mit einem gefurchten Abschnitt (13a), wobei der Susceptor in dem Reaktor installiert ist;
der Susceptor (13) mit einer AlaGabIncN-(a+b+c =1, a>0)-Schicht (21) bedeckt ist,
die Oberfläche des gefurchten Abschnitts (13a) nicht mit der AlaGabIncN-Schicht (21) bedeckt ist,
der gefurchte Abschnitt angepasst ist, ein Substrat (12) zu halten;
einem Heizer (14), der angepasst ist, das Substrat (12), das in dem gefurchten Abschnitt (13a) gehalten wird, über den Susceptor (13) zu heizen.

10. Vorrichtung nach Anspruch 9, ferner mit dem Substrat, wobei der gefurchte Abschnitt (13a) so gebildet ist, dass ein Oberflächenniveau des Substrats (12), das in den gefurchten Abschnitt (13a) gesetzt ist, das gleiche ist wie ein Oberflächenniveau der AlaGabIncN-(a+b+c =1, a>0)-Schicht (21).

11. Herstellungsverfahren nach Anspruch 9 oder 10, wobei die AlaGabIncN-(a+b+c =1, a>0)-Schicht (21) 50 Atomprozent oder mehr von einem Al-Element (a>0,5) für alle der III-Elemente enthält.

12. Herstellungsverfahren nach Anspruch 11, wobei die AlaGabIncN-(a+b+c =1, a>0)-Schicht (21) aus einer AIN-Schicht besteht.

13. Herstellungsvorrichtung nach einem der Ansprüche 9 bis 12, wobei die AlaGabIncN-(a+b+c =1, a>0)-Schicht (21) einen inneren Abschnitt des Reaktors (11) bedeckt, der auf 1000 °C oder mehr zu heizen ist.

## Revendications

1. Procédé permettant de fabriquer un film de nitrure III-V, comprenant les étapes qui consistent :
à préparer un suscepteur (13) dans un réacteur (11), où le suscepteur (13) comprend une partie rainurée (13a) et le suscepteur (13) est revêtu d'un premier film AlaGabIncN (a+b+c=1, a>0), et la surface de la partie rainurée (13a) n'est pas revêtue du premier film AlaGabIncN ;
à placer un substrat (12) dans la partie rainurée ;
à chauffer le substrat (12) à une température prédéterminée ; et
à introduire un gaz de matière première III et un gaz de matière première V avec un gaz porteur sur le substrat (12) préparé dans le réacteur (11), et ainsi, à fabriquer un deuxième film AlxGayInzN (x+y+z=1) par un procédé de MOCVD.

2. Procédé de fabrication selon la revendication 1, dans lequel la partie rainurée (13a) est formée de sorte qu'un niveau de surface du substrat (12) placé dans la partie rainurée (13a) soit le même qu'un niveau de surface du premier film (21) AlaGabIncN (a+b+c=1, a>0).

3. Procédé de fabrication selon la revendication 1 ou 2, dans lequel le premier film (21) AlaGabIncN (a+b+c=1, a>0) comporte 50 en pourcentages atomiques ou plus d'Al élémentaire (a>0,5) pour tous les éléments III.

4. Procédé de fabrication selon la revendication 3, dans lequel le premier film (21) AlaGabIncN (a+b+c=1, a>0) est composé d'un film AIN.

5. Procédé de fabrication selon l'une des revendications 1 à 4, dans lequel le deuxième film AlxGayInzN (x+y+z=1) comporte 50 en pourcentages atomiques ou plus d'élément Al (a>0,5) pour tous les éléments III.

6. Procédé de fabrication selon la revendication 5, dans lequel le film AlxGayInzN (x+y+z=1) est composé d'un film AIN.

7. Procédé de fabrication selon l'une des revendications 1 à 6, dans lequel le chauffage est effectué de sorte qu'une partie interne du réacteur (11) soit chauffée à 1000°C ou plus, et le premier film (21) AlaGabIncN (a+b+c=1, a>0) est revêtu sur la partie interne.

8. Procédé de fabrication selon l'une des revendications 1 à 7, comprenant en outre le fait
de former le premier film (21) AlaGabIncN (a+b+c=1, a>0) avant de placer le substrat dans le suscepteur.

9. Appareil permettant de fabriquer un film de nitrure III-V par une réaction de MOCVD, comprenant :
un réacteur (11) dans lequel la réaction de MOCVD entre un gaz de matière première III et un gaz de matière première V peut être générée ;
un suscepteur (13) avec une partie rainurée (13a), où le suscepteur est installé dans le réacteur ;
le suscepteur (13) est revêtu d'un film (21) AlaGabIncN (a+b+c=1, a>0),
la surface de la partie rainurée (13a) n'est pas revêtue du film (21) AlaGabIncN,
la partie rainurée est adaptée pour maintenir un substrat (12) ;
une unité de chauffage (14) adaptée pour chauffer le substrat (12) maintenu dans la partie rainurée (13a) par l'intermédiaire du suscepteur (13).

10. Appareil selon la revendication 9, comprenant en outre le substrat, où la partie rainurée (13a) est formée de sorte qu'un niveau de surface du substrat (12) placé dans la partie rainurée (13a) soit le même qu'un niveau de surface du film (21) AlaGabIncN (a+b+c=1, a>0).

11. Appareil de fabrication selon la revendication 9 ou 10, dans lequel le film (21) AlaGabIncN (a+b+c=1, a>0) comporte 50 en pourcentages atomiques ou plus d'élément Al (a>0,5) pour tous les éléments III.

12. Appareil de fabrication selon la revendication 11, dans lequel le film (21) AlaGabIncN (a+b+c=1, a>0) est composé d'un film AIN.

13. Appareil de fabrication selon l'une des revendications 9 à 12, dans lequel le film (21) AlaGabIncN (a+b+c=1, a>0) est revêtu sur une partie interne du réacteur (11) qui doit être chauffée à 1000°C ou plus.
